# EUROPEAN PATENT APPLICATION

(11) **EP 2 416 348 A1**
(43) Date of publication of application: **08.02.2012**
(21) Application number: 10761500.7
(22) Date of filing: 17.02.2010
(51) Int. Cl.: H01L 21/027, G11B 5/84, G11B 5/855, H01L 21/768, H01L 23/522

(54) **PATTERNING METHOD**

(30) Priority: 30.03.2009 JP 2009082457
(71) Applicant: FUJIFILM Corporation, Tokyo 106-8620 (JP)
(72) Inventor: WAKAMATSU, Satoshi, Odawara-shi Kanagawa 250-0001 (JP); YAMASHITA, Noriko, Odawara-shi Kanagawa 250-0001 (JP)
(74) Representative: HOFFMANN EITLE
(86) International application number: PCT/JP2010/052342
(87) International publication number: WO 2010/116798

(57) **Abstract**

To provide a pattern forming method, which contains: providing an active species-supplying source to a pattern formable body; and applying excitation light to the active species-supplying source to form an oxide film on a surface of the pattern formable body.

## Description

### Technical Field

The present invention relates to a pattern forming method that can be used for reproductions of a mold structure, as well as formations of patterns in semiconductor elements and magnetic recording media.

### Background Art

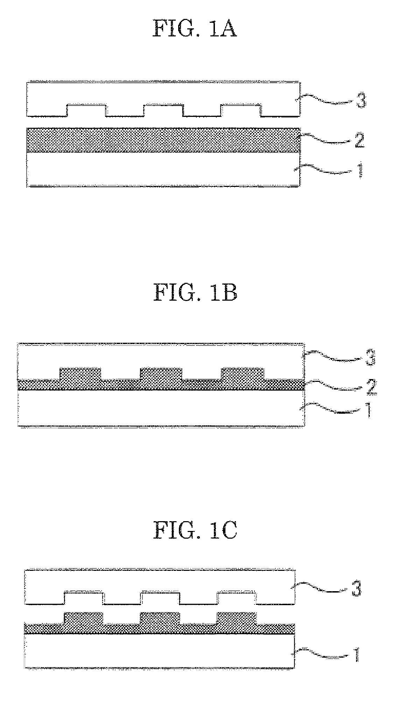

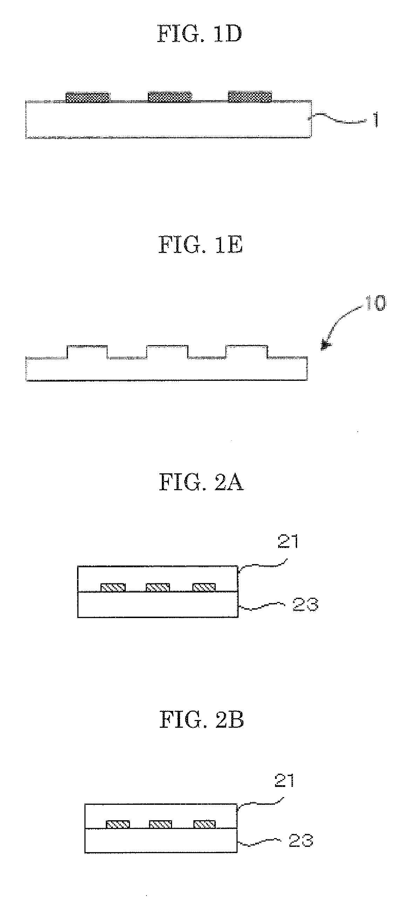

The nanoimprint lithography involves, as illustrated in FIGs. 1A to 1E, pressing a mold structure 3 having a convex-concave pattern on its surface against a resin layer 2 of a substrate 1 on a surface of which the resin layer 2 has been formed, and transferring the convex-concave pattern of the mold structure 3 to the resin layer 2. Then, etching is performed on the substrate 1 with using the convex parts formed in the resin layer as a mask. The resulting structure (mold structure) 10 has a pattern, which has been inversely transferred from the pattern of the mold structure.

In the past, as a patterning method, for example, an anodization patterning method using a conductive mold structure has been proposed (see PTL 1). In this proposed method, however, regions of a substrate corresponding to convex parts of the mold structure have concave parts of the substrate after etching, and therefore the pattern is inversely formed. In the nanoimprint lithography as mentioned, to produce (reproduce) a mold structure having a non-inversed pattern, it was necessary to repeat the nanoimprint lithography process twice (from the master to negative to positive). As a result of this, there were problems that the process is complicated, the defect occurring rate is high, and the accuracy is low. In addition, as the nanoimprinting device required a voltage application unit, there was problem that a cost was high.

Moreover, as a pattern forming method other than the nanoimprint lithography, for example, a method for patterning by an oxidation reaction using an optical catalyst pattern has been proposed (see PTL 2). In this proposed method, however, there was a space between the optical catalyst pattern and a substrate to which a pattern is transferred, and therefore the decomposition ability reduced, which caused a problem that is was difficult to form a fine pattern of nano order.

Furthermore, the conventional oxide film forming method has a problem that a complicated process is required. For example, in the case of a process for a semiconductor, a resist on a substrate is removed, and then oxidization is performed in plasma.

Accordingly, it is a current situation that there is a strong demand for providing a pattern forming method capable of forming fine pattern easily and efficiently without causing many defects.

### Citation List

### Patent Literature

PTL 1 Japanese Patent Application Laid-Open (JP-A) No. 2007-73712
PTL 2 Japanese Patent Application Laid-Open (JP-A) No. 2003-236390

### Summary of Invention

### Technical Problem

The present invention solves the various problems in the conventional art, and achieves the following object. Namely, an object of the present invention is to provide a pattern forming method that can easily and efficiently form a fine pattern with hardly any defect.

### Solution to Problem

As a result of the delight studies and researches conducted by the present inventors for solving the aforementioned problems, the present inventors have attained the following insights. Specifically, when water or hydrogen peroxide, which is an active species-supplying source, is applied to a pattern formable body, and excitation light (ultraviolet rays) is applied thereto, active oxygen, which is active species, is generated from the active species-supplying source. Since the active oxygen generated by the application of the excitation light has high oxidation-reduction potential, it oxidizes a surface of the pattern formable body at high reactivity to form an oxide film. In the manner as mentioned, a pattern of the oxide film can be formed on the surface of the pattern formable body.

The present invention is based upon the insights of the present inventors, and means for solving the aforementioned problems are as follows:
<1> A pattern forming method, containing:
   providing an active species-supplying source to a pattern formable body; and
   applying excitation light to the active species-supplying source to form an oxide film on a surface of the pattern formable body.
<2> The pattern forming method according to <1>, wherein the providing contains: a process of providing the active species-supplying source to the pattern formable body, or a mold structure having convex-concave parts on a surface thereof, or both the pattern formable body and the mold structure; and a process of bringing the convex-concave parts of the mold structure into contact with the pattern formable body, and
   wherein the applying is applying the excitation light to the active species-supplying source through either the mold structure or the pattern formable body to thereby form the oxide film on a region in the surface of the pattern formable body corresponding to the convex-concave parts of the mold structure.
<3> The pattern forming method according to any of <1> or <2>, wherein the pattern formable body contains a metal, or a semiconductor at least at a surface thereof.
<4> The pattern forming method according to any one of <1> to <3>, wherein the pattern formable body contains an organic thin film formed at a surface thereof.
<5> The pattern forming method according to any one of <1> to <4>, wherein the mold structure is formed of quartz, or a transparent resin.
<6> The pattern forming method according to any one of <1> to <5>, wherein the active species-supplying source contains water or hydrogen peroxide.
<7> The pattern forming method according to any one of <1> to <6>, wherein the excitation light contains ultraviolet rays.

### Advantageous Effects of Invention

By the present invention, the various problems in the conventional art can be solved, and there is provided a pattern forming method that can easily and efficiently form a fine pattern with hardly any defect.

### Brief Description of Drawings

FIG. 1A is a process drawing for explaining the conventional nanoimprint lithography (part 1).
FIG. 1B is a process drawing for explaining the conventional nanoimprint lithography (part 2).
FIG. 1C is a process drawing for explaining the conventional nanoimprint lithography (part 3).
FIG. 1D is a process drawing for explaining the conventional nanoimprint lithography (part 4).
FIG. 1E is a process drawing for explaining the conventional nanoimprint lithography (part 5).
FIG. 2A is a process drawing for explaining one example of the pattern forming method of the present invention (part 1).
FIG. 2B is a process drawing for explaining one example of the pattern forming method of the present invention (part 2).
FIG. 2C is a process drawing for explaining one example of the pattern forming method of the present invention (part 3).
FIG. 2D is a process drawing for explaining one example of the pattern forming method of the present invention (part 4).
FIG. 3A is a process drawing for explaining one example of the pattern forming method of the present invention (part 1).
FIG. 3B is a process drawing for explaining one example of the pattern forming method of the present invention (part 2).
FIG. 3C is a process drawing for explaining one example of the pattern forming method of the present invention (part 3).
FIG. 3D is a process drawing for explaining one example of the pattern forming method of the present invention (part 4).
FIG. 4A is a process drawing for explaining one example of the pattern forming method of the present invention (part 1).
FIG. 4B is a process drawing for explaining one example of the pattern forming method of the present invention (part 2).
FIG. 4C is a process drawing for explaining one example of the pattern forming method of the present invention (part 3).
FIG. 4D is a process drawing for explaining one example of the pattern forming method of the present invention (part 4).
FIG. 5A is a process drawing for explaining one example of the pattern forming method of the present invention (part 1).
FIG. 5B is a process drawing for explaining one example of the pattern forming method of the present invention (part 2).
FIG. 5C is a process drawing for explaining one example of the pattern forming method of the present invention (part 3).
FIG. 5D is a process drawing for explaining one example of the pattern forming method of the present invention (part 4).
FIG. 6 is a diagram showing one example of an AFM friction image of the oxide film pattern that has been formed by the pattern forming method of the present invention.

### Description of Embodiments

### (Pattern Forming Method)

The pattern forming method of the present invention contains at least an active species-supplying source providing step, and an oxide film forming step, and may further other steps, if necessary.

### <Active Species-Supplying Source Providing Step>

The active species-supplying source providing step is providing an active species-supplying source to a pattern formable body.

A method for providing the active species-supplying source to the pattern formable body is appropriately selected depending on the intended purpose without any restriction, and examples thereof include: a method in which an active species-supplying source is directly provided to a pattern formable body according to a pattern to be formed; a method in which an active-species-supplying source is provided to the pattern formable body by the two processes, i.e. a process of providing the active species-supplying source to at least either of the pattern formable body, or a mold structure having convex-concave parts on the surface thereof (i.e. an active species-supplying source providing process), and a process of bringing the convex-concave parts of the mold structure into contact with the pattern formable body (i.e. a contacting process). Among them, the method in which an active-species-supplying source is provided to the pattern formable body by the process of providing the active species-supplying source to the pattern formable body, and the process of bringing the convex-concave parts of the mold structure into contact with the pattern formable body is preferable.

### -Pattern Formable Body-

An embodiment of the pattern formable body is appropriately selected depending on the intended purpose without any restriction, provided that it can form an oxide film on the surface thereof with active species, and examples thereof include: an embodiment in which the pattern formable body is formed of a material that can form an oxide film with assistance of active species on the entire body thereof (hereinafter, this embodiment may be referred to as "first embodiment"); an embodiment in which the pattern formable body contains a material capable of forming an oxide film on a surface of a substrate (hereinafter, this embodiment may be referred to as "second embodiment"); an embodiment in which in addition to the first embodiment, an organic thin film provided on a surface of the material capable of forming the oxide film, and formed of an organic material that is oxidative degradable with the active species (hereinafter, this embodiment may be referred to as "third embodiment"); and an embodiment in which in addition to the second embodiment, an organic thin film provided on a surface of the material capable of forming the oxide film, and formed of an organic material that is oxidative degradable with the active species (hereinafter, this embodiment may be referred to as "fourth embodiment"). Among them, the third embodiment and the fourth embodiment are preferable because with these embodiments, the material for forming the oxide film is prevented from being oxide by being in contact with the air.

In the third embodiment and the fourth embodiment, after oxidative degrading the organic thin film with the active species to remove, an oxide film can be formed on a substrate which contains the material capable of forming an oxide film that has been exposed as a result of the removal of the organic thin film.

### --Material Capable of Forming Oxide Film--

The material capable of forming an oxide film is appropriately selected depending on the intended purpose without any restriction. Metals, semiconductors, and resins are preferable as the material capable of forming the oxide film with the metals and semiconductors being more preferable.

The metal is appropriately selected depending on the intended purpose without any restriction, and examples thereof include aluminum, zinc, titanium, chromium, iron, nickel, lead, and cobalt alloys. Among them, aluminum is preferable as it is a metal that is easily oxidized.

The semiconductor is appropriately selected depending on the intended purpose without any restriction, and examples thereof include silicon (Si), germanium, gallium-arsenic (GaAs), and indium phosphorus (InP). Among them, silicon is preferable as it is a semiconductor that is easily oxidized.

The resin is appropriately selected depending on the intended purpose without any restriction, and examples thereof include resins containing polysilane.

In the case of the embodiment in which the pattern formable body contains the material capable of forming an oxide film on a surface of the substrate, a thickness of the material capable of forming an oxide film is appropriately selected depending on the intended purpose without any restriction, the thickness thereof is, for example, 5 nm to 300 nm.

A formation method of the material capable of forming the oxide film on a surface of the substrate is appropriately selected depending on the intended purpose without any restriction, and examples thereof include sputtering, vapor deposition, spin coating, dip coating, and spray coating.

### --Organic Thin Film--

The organic material for forming the organic thin film is appropriately selected depending on the intended purpose without any restriction, provided that it is oxidative degradable by the active species, and examples thereof include polyethylene terephthalate (PET), polyethylene naphthalate (PEN), polycarbonate (PC), low-melting point fluororesin, polymethyl methacrylate (PMMA), and triacetate cellulose (TAC).

Among them, PMMA is particularly preferable as the oxidative degradation thereof is easily caused by the active species, and has excellent properties as a mask.

A thickness of the organic thin film is appropriately selected depending on the intended purpose without any restriction, but it is preferably 5 nm to 300 nm.

A formation method of the organic thin film is appropriately selected depending on the intended purpose without any restriction, and examples thereof include spin coating, dip coating, and spray coating.

### --substrate--

The substrate is appropriately selected depending on the intended purpose without any restriction in its shape, structure, size, material.

The shape of the substrate is, for example, a disk shape in the case where it is used for forming an information recording medium.

The structure of the substrate may be a single layer structure, or a laminate structure.

The material of the substrate is appropriately selected from substrate materials known in the art, and examples thereof include nickel, aluminum, glass, silicon, quartz, and transparent resins. These substrate materials may be used independently, or in combination. Among them, quartz, glass, and transparent resins are preferable, and quartz is particularly preferable in light of their transparency.

The substrate may be obtained by appropriately synthesizing, or obtained from the commercial products.

A thickness of the substrate is appropriately selected depending on the intended purpose without any restriction, but it is preferably 50 µm or larger, more preferably 100 µm or larger. When the thickness of the substrate is smaller than 50 µm, bending occurs at the side of the mold structure when the pattern formable body and the mold structure are made closely fitted, and therefore it may not be possible to secure the uniformly closely fitted state.

### -Mold Structure-

The mold structure is appropriately selected depending on the intended purpose without any restriction. For example, the mold structure contains a disk shaped substrate, and convex-concave parts formed by aligning a plurality of convexities on one surface of the substrate based on the surface, and may further contain other structures.

A material of the mold structure is appropriately selected depending on the intended purpose without any restriction, provided that it is transparent and it transmits excitation light through, but it is preferably any material selected from quartz, glass and a transparent resin. A wavelength of the excitation light is appropriately selected depending on the active species-supplying source for use, but the excitation light is preferably ultraviolet rays.

Examples of the transparent resin include polyethylene terephthalate (PET), polyethylene naphthalate (PEN), polycarbonate (PC), low-melting point fluororesin, polymethyl methacrylate (PMMA), and polydimethylsiloxane (PDMS).

The mold structure preferably has transmittance of 30% or higher relative to the excitation light, in view of the application of the excitation light to the pattern formable body, and as the mold structure, quartz, which is excellent in light transmittance, is particularly preferable.

Note that, an optical catalyst layer may be formed on the convex-concave parts of the mold structure to enhance the generating rate of the active oxygen. Examples of the optical catalyst layer include layers formed of titanium oxide, tin oxide, and the like.

### -Active Species-Supplying Source-

Examples of active species in the active species-supplying source include active oxygen (e.g. super oxide anion radicals, hydroxyl radicals, hydrogen peroxide, and singlet oxygen).

Examples of the active species-supplying source include water (moisture), and hydrogen peroxide, and the active species-supplying source may contain oxygen, ozone, and the like, but hydrogen peroxide is particularly preferable as the active species-supplying source as it easily generates hydroxyl radicals which serve as active species.

### -Providing Active Species-Supplying Source (Active Speeies-Supplying Source Providing Process)-

The active species-supplying source is provided directly to the pattern formable body according to a pattern to be formed, or provided to the pattern formable body through a process of providing the active species-supplying source to at least either the pattern formable body or the mold structure having convex-concave parts on the surface thereof, and a process of bringing the convex-concave parts of the mold structure, which will be explained later, into contact with the pattern formable body.

A method for providing the active species-supplying source is appropriately selected depending on the intended purpose without any restriction, and examples thereof include coating, immersion, and spraying. Examples of the providing method include spin coating, dip coating, spray coating, and inkjet coating.

An amount of the active species-supplying source provided is appropriately selected depending on the intended purpose without any restriction, provided that a sufficient amount of the active species-supplying source is secured on the convex parts or concave parts of the mold structure.

Note that, a pattern of an oxide film to be obtained can be selected by performing hydrophobic processing or hydrophilic processing on the surface of the mold structure. Specifically, in the case where the surface of the mold structure is subjected to a hydrophilic processing, the active species-supplying source is retained in concave parts of the mold structure, and as a result an oxide film pattern corresponding to the concave parts is formed on a surface of the pattern formable body. Meanwhile, in the case where the surface of the mold structure is subjected to a hydrophobic processing, the active species-supplying source is retained on the convex parts of the mold structure, and as a result an oxide film pattern corresponding to the concave parts is formed on a surface of the pattern formable body.

The hydrophilic processing is appropriately selected depending on the intended purpose without any restriction, and examples thereof include surface modifications by an application of a surfactant, UV ozone processing, and the like.

The hydrophobic processing is appropriately selected depending on the intended purpose without any restriction, and examples thereof include surface modification with a fluorine-based material.

### ·Contacting Process-

The contacting process is a process of bringing the convex-concave parts of the mold structure into contact with the pattern formable body.

The applied pressure during the contact is appropriately selected depending on the intended purpose without any restriction.

In the case where the surface of the mold structure is subjected to the hydrophilic processing, the applied pressure during the contact is appropriately selected depending on the intended purpose without any restriction, but it is preferably 0.1 MPa to 10 MPa because the larger the applied pressure is the more amount of the active species-supplying source between the convex parts of the mold structure and the pattern formable body is removed, which reduces the oxidation reaction of active species at the convex portion.

In the case where the surface of the mold structure is subjected to hydrophobic processing, the applied pressure during the contact is appropriately selected depending on the intended purpose without any restriction, but it is preferably 10 Pa to 0.1 MPa, because the application of the excessively large pressure removes the active species-supplying source between the convex parts of the mold structure and the pattern formable body, which may inhibit the appropriate oxidation reaction at the convex portions.

### <Oxide Film Forming Step>

The oxide film forming step is applying excitation light to the active species-suppiying source through the mold structure or the pattern formable body, to form an oxide film corresponding to the convex-concave parts of the mold structure on a surface of the pattern formable body.

The excitation light is appropriately selected depending on the intended purpose without any restriction, but it is preferably a light source including either the wavelength of 184.9 nm or 253.7 nm, and examples of the light source include a low pressure mercury lamp, an excimer lamp, and a high pressure mercury lamp.

The irradiation dose of the excitation light is appropriately selected depending on a target of an oxidation reaction for use, and the intended thickness of an oxide film, without any restriction. In the case where a low pressure mercury lamp is used, for example, the application of the excitation light is preferably performed for 1 minute to 30 minutes at the irradiation intensity of 30 mW/cm².

Once the excitation light is applied, active species are generated from the active species-supplying source, and the generated active species oxidizes a region of the surface of the pattern formable body corresponding to the convex-concave parts of the mold structure. Then, with the separation between the pattern formable body and the mold structure, an oxide film pattern is formed on the surface of the pattern formable body.

The excitation light passes through the transparent mold structure to be applied, but in the case where a transparent material is used in the pattern formable body, the excitation light may be applied by passing through the pattern formable body.

### <Confirmation of Formation of Oxide Film Pattern>

A method for confirming whether an oxide film pattern is formed is appropriately selected depending on the intended purpose without any restriction, and examples thereof include a method for confirming with a friction image obtained by an atomic force microscope (AFM).

From the friction image of the atomic force microscope, a contrast can be observed from a difference in surface textures between that of the oxide region and the non-oxide region. Specifically, the friction has increased in the oxide region compared to that in the non-oxide region. This can be understood that the interaction between the oxide region and a surface of the AFM probe increases in the AFM measurement in the air, as the surface energy locally increases due to oxidation.

### (Use)

Use of the pattern forming method of the present invention is appropriately selected depending on the intended purpose without any restriction, and examples thereof include a reproduction method of a mold structure, a fine pattern forming method for a semiconductor element, and a fine pattern forming method for a magnetic recording medium.

### -Mold Structure Reproduction Method-

Examples of the reproduction method of a mold structure include a method containing etching a pattern formable body using an oxide film, which has been formed on a surface of the pattern formable body by the pattern forming method of the invention, as a mask.

The etching is appropriately selected depending on the intended purpose without any restriction, and it may be wet-etching, or dry-etching.

Examples of the wet-etching include wet-etching using a base aqueous solution such as of KOH to Si, wet-etching using a fluorine-based aqueous solution such as of HF to SiO₂, and wet-etching using an acid aqueous solution such as hydrochloric acid to a metal.

Examples of the dry-etching include RIE, and ion milling. A gas used for the dry-etching is appropriately selected depending on materials used for the pattern formable body.

By the etching, a convex-concave pattern corresponding to the convex-concave pattern of the mold structure can be formed in the pattern formable body.

### -Fine Pattern Forming Method for Semiconductor Element-

One example of the fine pattern forming method for a semiconductor element is a method in which a Si substrate is used as the pattern formable body, and the Si substrate is subjected to wet-etching using as a mask an oxide film pattern formed on a surface of the Si substrate by the pattern forming method of the invention.

Examples of the wet-etching include wet-etching using a KOH aqueous solution, wet-etching using ethylenediamine pyrocatechol (EDP), and wet-etching tetramethylammonium hydroxide (TMAH).

By the etching, a convex-concave pattern corresponding to the convex-concave pattern of the mold structure can be formed in the pattern formable body.

Another example of the fine pattern forming method for a semiconductor element is a method in which a pattern formable body having a metal forming passivity at the surface thereof is used as the pattern formable body, and the pattern formable body is subjected to wet-etching with acid using as a mask an oxide film (passivity) formed at the surface of the metal by the pattern forming method of the invention.

By carrying out this method on a metal thin film formed on a Si substrate or quartz substrate, a metal mask for etching of the substrate can be formed.

### -Fine Pattern Forming Method of Magnetic Recording Medium-

As an example of the fine pattern forming method of a magnetic recording medium, it is assumed that it is possible to form a magnetic pattern by the pattern forming method of the present invention, by using a magnetic recording medium as the pattern formable body, forming an oxide film pattern on a surface of a magnetic body of the magnetic recording medium, and degrading the magnetism of the region on which the oxide film has been formed.

Moreover, it is possible that a passivity mask is formed on a surface of the magnetic body, and a metal mask is formed by wet-etching as in the manner mentioned in the fine pattern forming method for semiconductor element described above, and the magnetic body is subjected to etching using the metal mask to produce discrete track media (DTM).

### Examples

Examples of the present invention will be explained hereinafter, but these examples shall not be construed as to limit the scope of the present invention in any way.

### (Example 1)

### <Formation of Oxide Film Pattern Using Hydrophilic-Processed Mold>

### -Mold Structure-

As a mold structure, a quartz mold structure having a line-space (LS) pattern having a half-pitch of 600 nm and a depth of 350 nm on the surface thereof was used. The quartz mold structure was subjected to a UV ozone treatment to make a surface of the quartz mold structure hydrophilic.

### -Pattern Formable Body-

As a pattern formable body, a Si wafer the surface of which was treated to give hydrogen terminals was used. Specifically, UV ozone processing was performed on a commercially available Si wafer (manufactured by Sin-Etsu Chemical Co., Ltd.) to oxidative degrade and remove an organic contaminate layer. Then, the Si wafer was treated with a 1% hydrofluoric acid diluted with ultra pure water, having the organic carbon (TOC) of 50 ppb or lower to remove an oxide film on the surface of the Si wafer. In the manner as mentioned, a Si substrate the surface of which was treated to give hydrogen terminals was produced.

### -Formation of Oxide Film Pattern-

A pattern was formed through the processes illustrated in FIGs. 2A to 2D.

In FIGs. 2A to 2D, "21" denotes a mold structure, "22" denotes an active species-supplying source, "23" denotes a pattern formable body, and "24a" denotes an oxide film pattern.

### --Active Species-Supplying Source Providing Step--

### ---Active Species-Supplying Source Providing Process---

On the Si wafer the surface of which was treated to give hydrogen terminals, water was applied dropwise as the active species-supplying source (see FIG. 2A).

### ---Contacting Process---

The convex-concave parts of the mold structure were pressed against the Si wafer, and pressurized at 0.5 MPa (see FIG. 2B).

Since the surface of the mold structure had been processed to have hydrophilicity, the water was retained in the concave parts of the mold structure.

### --Oxide Film Forming Step--

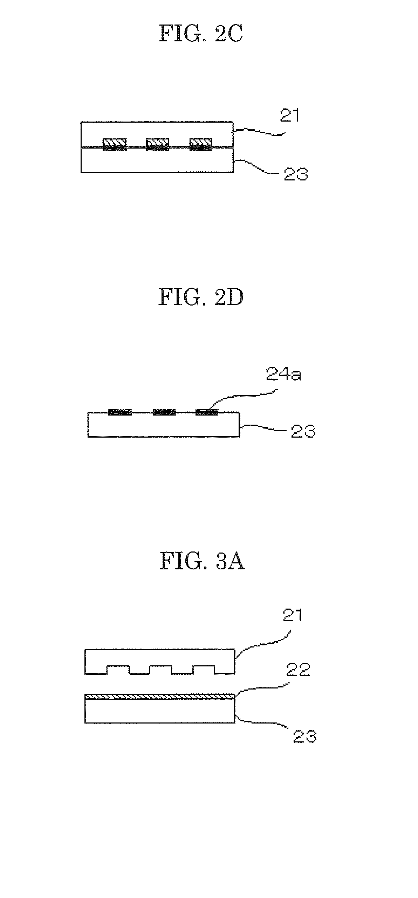

Next, ultraviolet rays were applied through the mold structure by a low pressure mercury lamp at irradiation intensity of 30 mW/cm² for 3 minutes (see FIG. 2C).

After the application of the ultraviolet rays, the Si wafer and the mold structure were separated from each other (see FIG. 2D).

A friction image of the Si wafer was observed by means of AFM (SPI4000/SPA-300HV, manufactured by SEIKO INSTRUMENTS INC.), and then it was confirmed that an oxide film was formed in the Si wafer at the regions corresponding to concave parts of the mold structure.

### (Example 2)

### < Formation of Oxide Film Pattern Using Hydrophobic-Processed Mold>

### -Mold Structure-

As a mold structure, a mold structure forming of polytetrafluoroethylene (PTFE) having a LS pattern, which included a half-pitch of 600 nm, and a depth of 350 nm, at a surface thereof was used.

### -Pattern Formable Body-

As a pattern formable body, a Si wafer the surface of which was treated to give hydrogen terminals, which was the same as the one used in Example 1, was used.

### -Formation of Oxide Film Pattern-

A pattern was formed through the processes illustrated in FIGs. 3A to 3D.

In FIGs. 3A to 3D, "21" denotes a mold structure, "22" denotes an active species-supplying source, "23" denotes a pattern formable body, "24" denotes an oxide film, and "24a" denotes an oxide film pattern.

### --Active Species-Supplying Source Providing Step--

### ---Active Species-Supplying Source Providing Process---

On the Si wafer the surface of which was treated to give hydrogen terminals, water was applied dropwise as the active species-supplying source (see FIG. 3A).

### ---Contacting Process---

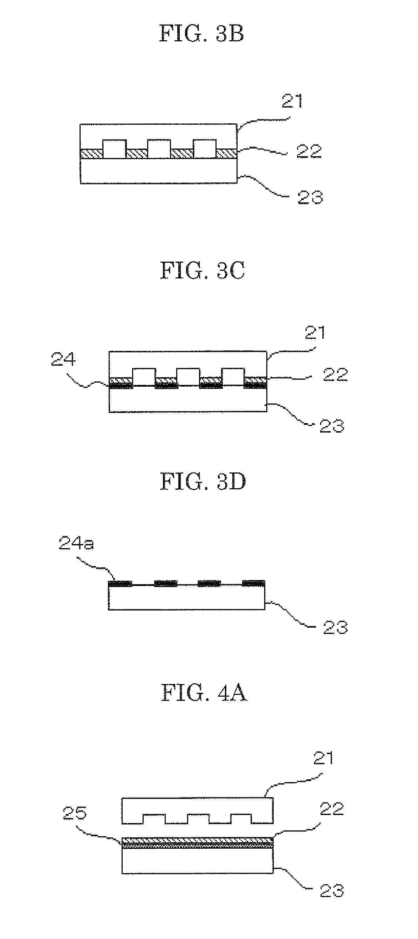

The convex-concave parts of the mold structure were pressed against the Si wafer, and pressurized at 10 Pa (see FIG. 3B).

Since the surface of the mold structure had been processed to have hydrophobicity, the water was retained on the convex parts of the mold structure.

### --Oxide Film Forming Step--

Next, ultraviolet rays were applied through the mold structure by a low pressure mercury lamp at irradiation intensity of 30 mW/cm² for 3 minutes (see FIG. 3C).

After the application of the ultraviolet rays, the Si wafer and the mold structure were separated from each other (see FIG. 3D).

A friction image of the Si wafer was observed by means of AFM (SPI4000/SPA-300HV, manufactured by SEIKO INSTRUMENTS INC.), and then it was confirmed that an oxide film was formed in the Si wafer at the regions corresponding to convex parts of the mold structure.

### (Example 3)

### <Formation of Oxide Film Pattern-1 to Pattern Formable Body on Surface of Which Organic Thin Film Be Formed>

### -Mold Structure-

As a mold structure, a hydrophilic-processed quartz mold structure, which was the same as that used in Example 1, was used.

### -Pattern Formable Body-

As a pattern formable body, a Si substrate, a surface of which had been treated with hexamethyldisilazane (HMDS), was used. Specifically, a solution containing HMDS was applied to a Si substrate by spin coating, and based for 15 minutes on a hot plate of 120°C, to thereby prepare the Si substrate on a surface of which an organic thin film formed of hexamethyldisilazane was formed.

### -Formation of Oxide Film Pattern-

A pattern was formed through the processes illustrated in FIGs. 4A to 4D.

In FIGs. 4A to 4D, "21" denotes a mold structure, "22" denotes an active species-supplying source, "23" denotes a pattern formable body, "24a" denotes an oxide film pattern, and "25" denotes an organic thin film.

### --Active Species-Supplying Source Providing Step--

### ---Active Species-Supplying Source Providing Process---

On the Si substrate, water was applied dropwise as the active species-supplying source (see FIG. 4A).

### ---Contacting Process---

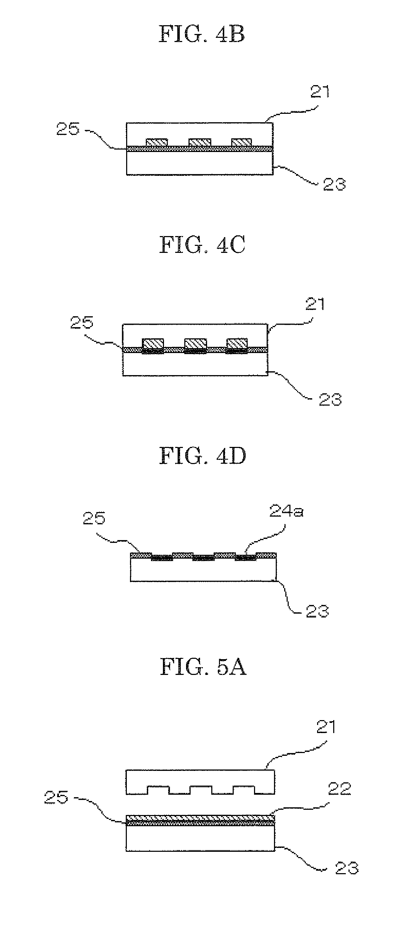

The convex-concave parts of the mold structure were pressed against the Si substrate, and pressurized at 0.5 MPa (see FIG. 4B).

Since the surface of the mold structure had been processed to have hydrophilicity, the water was retained in the concave parts of the mold structure.

### --Oxide Film Forming Step--

Next, ultraviolet rays were applied through the mold structure by a low pressure mercury lamp at irradiation intensity of 30 mW/cm² for 3 minutes (see FIG. 4C).

After the application of the ultraviolet rays, the Si substrate and the mold structure were separated from each other (see FIG. 4D).

A friction image of the Si substrate was observed by means of AFM (SPI4000/SPA-300HV, manufactured by SEIKO INSTRUMENTS INC.), and then it was confirmed that at the regions of the Si substrate corresponding to the concave parts of the mold structure, the HDMS layer was decomposed and removed by the oxidation reaction, and an oxide film was formed on the exposed surface of the Si substrate.

### (Example 4)

### < Formation of Oxide Film Pattern-2 to Pattern Formable Body on Surface of Which Organic Thin Film Be Formed>

### -Mold Structure-

As a mold structure, a mold structure formed of polytetrafluoroethylene (PTFE) with a surface thereof being subjected to hydrophobic processing, which was the same as the one used in Example 2, was used.

### -Pattern Formable Body-

As a pattern formable body, a Si substrate having at the surface thereof an organic thin film formed of hexamethyldisilazane, which has the same as the one used in Example 3, was used.

### -Formation of Oxide Film Pattern-

A pattern was formed through the processes illustrated in FIGs. 5A to 5D.

In FIGs. 5A to 5D, "21" denotes a mold structure, "22" denotes an active species-supplying source, "23" denotes a pattern formable body, "24" denotes an oxide film, "24a" denotes an oxide film pattern, and "25" denotes an organic thin film.

### --Active Species-Supplying Source Providing Step--

### ---Active Species-Supplying Source Providing Process---

On the Si substrate, water was applied dropwise as the active species-supplying source (see FIG. 5A).

### ---Contacting Process---

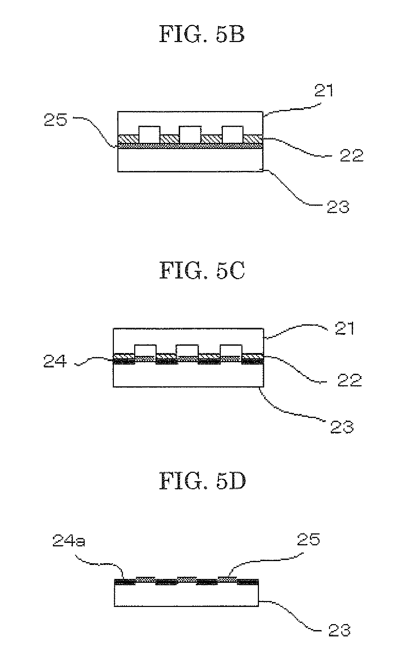

The convex-concave parts of the mold structure were pressed against the Si substrate, and pressurized at 10 Pa (see FIG. 5B).

Since the surface of the mold structure had been processed to have hydrophobicity, the water was retained on the convex parts of the mold structure.

### --Oxide Film Forming Step--

Next, ultraviolet rays were applied through the mold structure by a low pressure mercury lamp at irradiation intensity of 30 mW/cm² for 3 minutes (see FIG. 5C).

After the application of the ultraviolet rays, the Si substrate and the mold structure were separated from each other (see FIG. 5D).

A friction image of the Si substrate was observed by means of AFM (SPI4000/SPA-300HV, manufactured by SEIKO INSTRUMENTS INC.), and then it was confirmed that at the regions of the Si substrate corresponding to the convex parts of the mold structure, the HDMS layer was decomposed and removed by the oxidation reaction, and an oxide film was formed on the exposed surface of the Si substrate.

### (Examples 5 to 8)

Formations of oxide film patterns in Examples 5 to 8 were performed in the same manner as in Example 1 to Example 4, respectively, provided that in the active species-supplying source providing process, hydrogen peroxide was applied instead of water. Friction images of the pattern formable bodies to which the oxide film pattern had been formed in Examples 5 to 8 were observed by means of AFM (SPI4000/SPA-300HV, manufactured by SEIKO INSTRUMENTS INC.), and then it was confirmed that an oxide film was formed at the regions of the Si wafer corresponding to the concave parts of the mold structure in Example 5; an oxide film was formed at the regions of the Si wafer corresponding to the convex parts of the mold structure in Example 6; at the regions of the Si substrate corresponding to the concave parts of the mold structure, the HDMS layer was decomposed and removed by the oxidation reaction, and an oxide film was formed on the exposed surface of the Si substrate in Example 7; and at the regions of the Si substrate corresponding to the convex parts of the mold structure, the HDMS layer was decomposed and removed by the oxidation reaction, and an oxide film was formed on the exposed surface of the Si substrate in Example 8.

### (Example 9)

### <Formation of Oxide Film Pattern on Magnetic Recording Medium>

### -Mold Structure-

As a mold structure, a quartz mold structure having at the surface thereof a line pattern, in which the width of the concave part was 4 um, and the width of the convex part was 16 µm, was used. The quartz mold structure was subjected to UV ozone processing to make a surface of the mold structure hydrophilic.

### -Pattern Formable Body-

As a pattern formable body, a commercially available hard disk (manufactured by Showa Denko K.K.) was used. As the commercially available hard disk had a lubricant layer and a carbon protective layer at a surface thereof, the lubricant layer and the carbon protective layer was removed by plasma ashing to thereby expose a magnetic layer to the surface.

### -Formation of Oxide Film Pattern-

A pattern was formed through the processes illustrated in FIGs. 2A to 2D.

### --Active Species-Supplying Source Providing Step--

### ---Active Species-Supplying Source Providing Process---

On the magnetic body of the hard disk, water was applied dropwise as the active species-supplying source (see FIG. 2A).

### ---Contacting Process---

The convex-concave parts of the mold structure were pressed against the hard disk, and pressurized at 0.5 MPa (see FIG. 2B).

Since the surface of the mold structure had been processed to have hydrophilicity, the water was retained in the concave parts of the mold structure.

### --Oxide Film Forming Step--

Next, ultraviolet rays were applied to the pattern formable body through the mold structure by a low pressure mercury lamp at irradiation intensity of 30 mW/cm² for 3 minutes (see FIG. 2C).

After the application of the ultraviolet rays, the hard disk and the mold structure were separated from each other (see FIG. 2D).

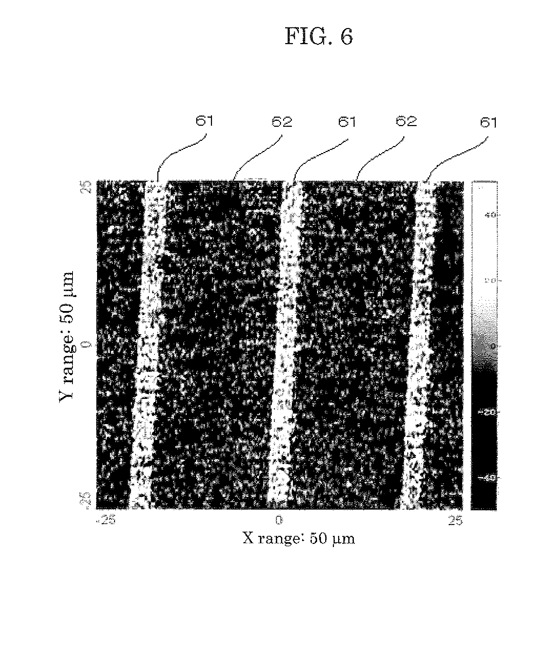

A result of the observation of the friction image under AFM (SPI4000/SPA-300HV, manufactured by SEIKO INSTRUMENTS INC.) was shown in FIG. 6.

In Example 9, as the surface of the mold structure was subjected to hydrophilic processing, the regions corresponding to the concave parts of the mold structure were oxidized, and a contrast was observed in the friction image with a difference in the surface condition of the non-oxide region 62. The friction force increased in the regions corresponding to the oxide region 61 compared to the non-oxide region 62. This can be understood that the interaction between the oxide region and a surface of the AFM probe increases in the AFM measurement in the air, as the surface energy locally increases due to oxidation.

From the observation as mentioned above, it was confirmed that an oxide film was formed at the regions of the surface of the magnetic body of the hard disk.

### <Evaluation on Defects>

The defects occurred in the pattern of the oxide film formed in each of Examples 1 to 9 was measured in the following manner and evaluated based on the evaluation standard below. The results are shown in Table 1.

### -Measurement of Deflects-

An AFM friction image was taken at the predetermined region of a 100 µm-side square (1024×1024 pixels) on the oxide film pattern, and a defect occurring rate was evaluated with the value which was obtained by dividing the pixel numbers of the defected line pattern by the total pixel numbers.

**Table 1**

| | Defect occurring rate |
|---|---|
| Ex. 1 | 4% |
| Ex. 2 | 10% |
| Ex. 3 | 3% |
| Ex. 4 | 5% |
| Ex. 5 | 3% |
| Ex. 6 | 5% |
| Ex. 7 | 1% |
| Ex. 8 | 2% |
| Ex. 9 | 1% |

From the results shown in Table 1, it was found that the oxide film patterns formed in Examples 1 to 9 had the low numbers of the defects. Among them, Examples 7 and 8, in which the hydrogen peroxide was used as the active species-supplying source, and the pattern formable body on the surface of which the organic thin film had been formed was used, had particularly the low numbers of the defects, and provided the excellent oxide films.

### Industrial Applicability

The pattern forming method of the present invention can easily and efficiently form a fine pattern with hardly any defect, and therefore it is extremely useful for reproductions of a mold structure, as well as formation of fine patterns in semiconductor elements, and magnetic recording media.

### Reference Signs List

- 1: substrate
- 2: resin layer
- 3: mold structure
- 10: structure
- 21: mold structure
- 22: active species-supplying source
- 23: pattern formable body
- 24: oxide film
- 24a: oxide film pattern
- 25: organic thin film
- 61: oxide region
- 62: non-oxide region

## Claims

1. A pattern forming method, comprising:
providing an active species-supplying source to a pattern formable body; and
applying excitation light to the active species-supplying source to form an oxide film on a surface of the pattern formable body.

2. The pattern forming method according to claim 1, wherein the providing contains: a process of providing the active species-supplying source to the pattern formable body, or a mold structure having convex-concave parts on a surface thereof, or both the pattern formable body and the mold structure; and a process of bringing the convex-concave parts of the mold structure into contact with the pattern formable body, and
wherein the applying is applying the excitation light to the active species-supplying source through either the mold structure or the pattern formable body to thereby form the oxide film on a region in the surface of the pattern formable body corresponding to the convex-concave parts of the mold structure.

3. The pattern forming method according to any of claim 1 or 2, wherein the pattern formable body contains a metal, or a semiconductor at least at a surface thereof.

4. The pattern forming method according to any one of claims 1 to 3, wherein the pattern formable body contains an organic thin film formed at a surface thereof.

5. The pattern forming method according to any one of claims 1 to 4, wherein the mold structure is formed of quartz, or a transparent resin.

6. The pattern forming method according to any one of claims 1 to 5, wherein the active species-supplying source contains water or hydrogen peroxide.

7. The pattern forming method according to any one of claims 1 to 6, wherein the excitation light contains ultraviolet rays.
